# EUROPÄISCHE PATENTSCHRIFT

(11) **EP 0 584 390 B1**
(45) Veröffentlichungstag und Bekanntmachung des Hinweises auf die Patenterteilung: **08.07.1998**
(21) Anmeldenummer: 92114662.7
(22) Anmeldetag: 27.08.1992
(51) Int. Cl.: G11C 11/409, G11C 7/00, G11C 7/06

(54) **Schaltungsanordnung zum Verstärken und Halten von Daten mit verschiedenen Versorgungsspannungen**
Circuit for the amplification and holding of data with different supply voltages
Circuit d'amplification et de maintien de données avec des tensions d'alimentation différentes

(43) Veröffentlichungstag der Anmeldung: 02.03.1994
(73) Patentinhaber: SIEMENS AKTIENGESELLSCHAFT, 80333 München (DE)
(72) Erfinder: Gleis, Dieter, Dr. Dipl.-Ing., W-8201 Grosskarolinenfeld (DE); Savignac, Dominique, Dr.rer.nat., W-8045 Ismaning (DE); Sommer, Diether, Dipl.-Phys., W-8000 München 5 (DE)

(56) Entgegenhaltungen:
- EP-A- 0 329 910
- EP-A- 0 464 468
- FR-A- 2 665 012
- US-A- 4 701 889

## Beschreibung

Die Erfindung betrifft eine Schaltungsanordnung zum Verstärken und Halten von Daten mit verschiedenen Versorgungsspannungen.

Derartige Schaltungen sind zumeist als bistabile Kippschaltungen ausgebildet und daher seit langem bekannt, wie z. B. in Tietze/Schenk Halbleiterschaltungstechnik 1986, 8. Auflage auf Seite 166ff beschrieben.

Zunehmende Speicherdichten integrierter Halbleiterspeicher erfordern eine immer größere Packungsdichte der Speicherzellen und damit eine Verkleinerung der Transistoren. Aus Zuverlässigkeitsgründen muß die Versorgungsspannung der minimalen Transistoren verringert werden. Der Anwender will aber weiterhin mit einer Versorgungsspannung von 5 Volt arbeiten. Deshalb ist eine Reduzierung der Versorgungsspannung auf dem Halbleiterspeicher notwendig geworden. Somit gibt es auf dem Speicher Schaltungen, die mit der externen hohen Versorgungsspannung und Schaltungen die mit der internen reduzierten Spannung betrieben werden.

Halbleiterspeicher sind in Matrixanordnung organisiert. Jede einzelne Speicherzelle ist dabei über eine Wortleitung (WL) und ein Bitleitungspaar (BL) ansprechbar. Ein Zugriff auf eine derartige Speicherzelle erfolgt durch Anlegen einer Adresse, die der Speicherzelle zugeordnet ist, an den Halbleiterspeicher sowie durch Anlegen der Zeilenadreßsteuersignale (Row Adress Strobe, RAS) und der Spaltenadreßsteuersignale (Column Adress Strobe, CAS). Üblicherweise wird mit dem Signal RAS die Zeilen- oder Wortadresse der Speicherzelle selektiert. Danach wird mit dem Signal CAS die Spaltenadresse gültig geschrieben und somit die Speicherzelle festgelegt.

Die über eine Wortleitung angesprochenen Speicherzellen werden ausgelesen und verstärkt. Die über die Spaltenadresse selektierten Bitleitungspaare, werden auf ein weiteres Leitungspaar geschaltet. Diese werden im allgemeinen externe Bitleitungen genannt werden. Zur Beschleunigung des Auslesevorgangs werden die Signale auf diesen Leitungen verstärkt und dann zum Datenausgang weitergeschaltet. Zur Reduzierung der Chipfläche besteht das Zellenfeld aus minimalen Transistoren und Strukturen. Die Spannung wird im Zellenfeld wie bereits obenbeschrieben reduziert. Deshalb ist es notwendig die Spannungspegel der Daten auf dem Datenpfad von der Speicherzelle vom Datenausgang entsprechend anzupassen.

Aus der EP-A-0 329 910 A1 ist ein zweistufiger Leseverstärker für RAMs mit einem Flip-Flop je Stufe bekannt, bei dem die Stufen serial über Bitleitungen, in die Schalt-Transistoren eingefügt sind, miteinander verbunden sind. Die Flip-Flops werden hierbei von einem Steuersignal angesprochen.

Aufgabe der vorliegenden Erfindung ist es daher, eine Schaltungsanordnung zum Verstärken und Halten von Daten anzugeben, die Daten mit einer niedrigeren Versorgungsspannung auswertet und auf eine höhere Versorgungsspannung verstärkt und ausgibt.

Diese Aufgabe wird durch den kennzeichnenden Teil des Anspruchs 1 gelöst. Weiterbildungen sind in den kennzeichnenden Teilen der Unteransprüche beschrieben.

Die Erfindung besteht im wesentlichen darin, daß zwei Flip-Flops derart miteinander verschaltet werden, daß die Gesamtanordnung ein äußeres und ein inneres Flip-Flop aufweist. Das innere Flip-Flop wird dabei mit der reduzierten Betriebsspannung betrieben. Das äußere Flip-Flop wird mit der hohen Versorgungsspannung, z. B. 5 Volt, betrieben. Die Verbindung zwischen innerem und äußerem Flip-Flop erfolgt dabei nur über Gateanschlüsse des äußeren Flip-Flops. Dies weist den Vorteil auf, daß keinerlei Einflüsse der beiden verschiedenen Versorgungsspannungen aufeinander auftreten können.

Wesentlich zum Funktionieren der erfindungsgemäßen Anordnung ist, daß zuerst das innere Flip-Flop aktiviert wird und nachfolgend das äußere. Dies kann z. B. durch eine einfache Logikschaltung erfolgen, die aus einem Aktivierungssignal durch ein Verzögerungselement 2 Aktivierungssignale erzeugt; ein verzögertes und ein unverzögertes, welche die jeweiligen Flip-Flop-Schaltkreise aktivieren.

Die Erfindung wird nachfolgend anhand von zwei Figuren näher erläutert. Es zeigen
Figur 1 eine erfindungsgemäße Schaltungsanordnung,
Figur 2 eine Ausführungsform für eine Ansteuerschaltung.

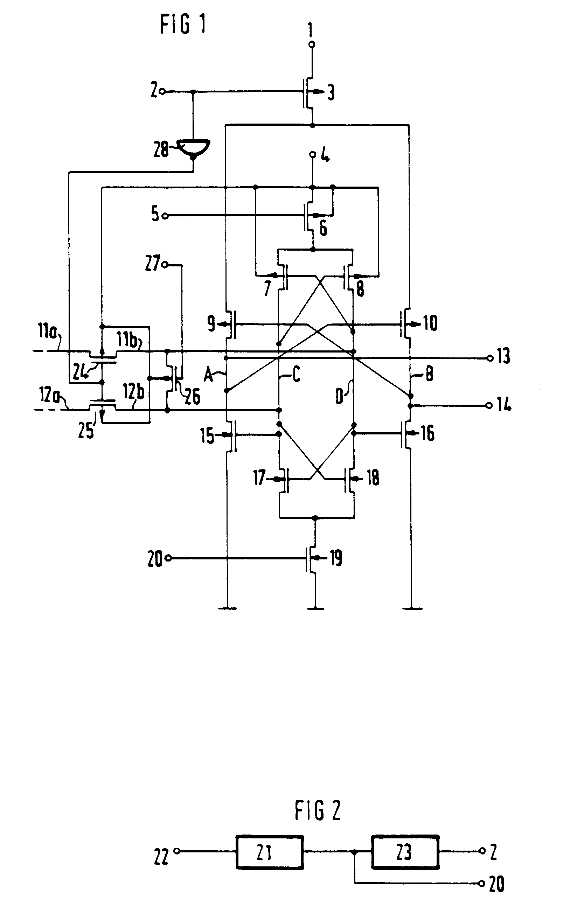

In Figur 1 ist mit 1 eine Versorgungsspannungsklemme für die höhere Versorgungsspannung, z. B. 5 Volt gekennzeichnet. Diese ist über die Laststrecke eine p-Kanal Aktivierungstransistors 3 jeweils mit den Drainanschlüssen zweier p-Kanal-FETS 9, 10 verbunden. Der Gateanschluß des Aktivierungstransistors 3 ist zum einen mit einer Anschlußklemme 2 und zum anderen mit dem Eingang eines Inverters 28 verschaltet. Der Sourceanschluß des p-Kanal-FETS 9 ist über die Laststrecke mindestens eines n-Kanal-FETS 15 mit Masse verschaltet. Ebenso ist der Sourceanschluß des P-Kanal-FETS 10 über die Laststreckeke mindestens eines n-Kanal-FETS 16 mit Masse verbunden. Der Gateanschluß des FETS 9 ist mit dem Knotenpunkt B der Reihenschaltung der Laststrecken der FETS 10, 16 und der Gateanschluß des FETS 10 mit dem Knotenpunkt A der Reihenschaltung der Laststrecken der FETS 9 und 15 verbunden. Eine Eingangsklemme 4 ist dargestellt, an der die niedrigere Versorgungsspannung, z. B. 3,3 Volt zuführbar ist. Diese Eingangsklemme 4 ist über die Laststrecke eines p-Kanal Aktivierungstransistors 6 mit den Drainanschlüssen zweier p-Kanal-FETS 7, 8 verbunden. Die Bulkanschlüsse der FETS 6, 7, 8 sind ebenfalls mit der Versorgungsspannungsklemme 4 verbunden. Der Gateanschluß des FETS 6 ist mit einer Anschlußklemme 5 verschaltet. Der Sourceanschluß des FETS 7 ist über die Laststrecke eines n-Kanal-FETS 17 mit dem Drainanschluß eines n-Kanal Aktivierungs-FETS 19 verschaltet. Ebenso ist der Sourceanschluß des FETS 8 über die Laststrecke eines n-Kanal-FETS 18 mit dem Drainanschluß des FETS 19 verbunden. Der Sourceanschluß des n-Kanal-FETS 19 ist mit Masse verschaltet und der Gateanschluß des FETS 19 ist mit einer Anschlußklemme 20 verbunden. Die Gateanschlüsse der FETS 8, 18 sind mit dem Knotenpunkt C der Reihenschaltung der Laststrecken der FETS 7 und 17 verbunden. Ebenso sind die Gateanschlüsse der FETS 7 und 17 mit dem Knotenpunkt D der Reihenschaltung der Laststrecken der FETS 8 und 18 verschaltet. Mit 11a,b und 12a,b sind die beiden externen Bitleitungen dargestellt, welche jeweils durch die Laststrecke eines p-Kanal-FETS 24, 25 unterbrochen sind um die externen Bitleitungen 11a, 12a von den Flip-Flops abtrennen zu können. Die Gateanschlüsse der FETS 24, 25 sind mit dem Ausgang des Inverters 28 verschaltet. Die Bulkanschlüsse der FETS 24, 25 sind mit der Versorgungsspannungsklemme 4 verbunden. Um während des Prechargevorgangs einen Potentialausgleich der externen Bitleitungsteile 11b, 12b zu gewährleisten, ist ein weiterer p-Kanal-FET 26 vorgesehen, dessen Laststrecke zwischen den externen Bitleitungsteilen 11b, 12b, geschaltet ist. Der Gateanschluß des FET 26 führt zu einer Anschlußklemme 27 und der Bulkanschluß ist wiederum mit der Versorgungsspannungsklemme 4 verbunden. Die externe Bitleitung 11b ist dabei mit dem Knotenpunkt D der Reihenschaltung der Laststrecken der FETS 8 und 18 und die externe Bitleitung 12b mit dem Knotenpunkt C der Reihenschaltung der Laststrecken der FETS 7 und 17 verbunden. Weiterhin ist der Knotenpunkt C der Reihenschaltung der Laststrecken der FETS 7, 17 mit dem Gateanschluß des FETS 15 und der Knotenpunkt D der Reihenschaltung der Laststrecken der FETS 8, 18 mit dem Gateanschluß des FETS 16 verbunden. Schließlich ist der Knotenpunkt A mit der Ausgangsklemme 13 und der Knotenpunkt B mit der Ausgangsklemme 14 verschaltet. An den beiden Ausgangsklemmen 13, 14 können die Datensignale mit der höheren Versorgungsspannung abgegriffen werden.

In Figur 2 ist eine Ansteuerschaltung zum Aktivieren der inneren und des äußeren Flip-Flops dargestellt. Mit 22 ist eine Anschlußklemme bezeichnet, an der ein Aktivierungssignal für die Auswerteschaltung zuführbar ist. Dieses Signal wird einer Logikanordnung 21 zugeführt. Diese Logikanordnung kann nicht näher dargestellte Ausgangssignale erzeugen, die z. B. zum Aktivieren und Deaktivieren der FETS 24, 25, 26 sowie verschiedener nicht dargestellter Steuer- und Auswerteeinrichtungen der Speicheranordnung dienen. So erzeugt die Logikeinheit 21 unter anderem das Signal zum Aktivieren des p-Kanal-FETS 6, da der eigentliche Einschaltvorgang für das innere Flip-Flop durch den Aktivierungs-FET 19 und für das äußere Flip-Flop durch den Aktivierungs-FET 3 erfolgt. Das von der Logikeinheit 21 erzeugte Aktivierungssignal zum Aktivieren der Schaltungsanordnung wird der Anschlußklemme 20 zugeführt, welche mit der in Figur 1 bezeichnenden Klemme 20 identisch ist. Weiterhin wird dieses Signal über eine Verzögerungseinheit 23 an die Anschlußklemme 2 geleitet. Die Anschlußklemme 2 ist ebenfalls mit der in Figur 1 dargestellten identisch. Im einfachsten Fall kann die Verzögerungseinheit 23 eine Inverterstufe sein. Wesentlich ist, daß das Signal welches von der Logikanordnung 21 erzeugt invertiert wird und um eine definierte Zeit, hierzu genügt z. B. eine Gatterlaufzeit, verzögert wird, so daß das innere Flip-Flop vor dem äußeren Flip-Flop aktiviert wird.

Bis eine Speicherzelle durch CAS festgelegt ist und der Datenausgang freigegeben wird, steuert die Spaltenadresse mit dem Signal, welches an der Eingangsklemme 22 zugeführt wird, den Lesevorgang. Von diesem Signal werden mehrere Signale abgeleitet, unter anderem die Signale welche den Anschlußklemmen 2 und 20 zugeführt werden.

Mit steigender Flanke des an der Eigangsklemme 22 anliegenden Signals werden die nicht dargestellten internen Bitleitungen und die externen Bitleitungen 11a,b, 12a,b vorgeladen und die Bewerter zurückgesetzt. Die Anordnungen zum Vorladen der Bitleileitungen sind in Figur 1 und Figur 2 nicht näher dargestellt und können in üblicher Weise ausgeführt sein. Das an der Anschlußklemme 22 anliegende Signal bewirkt mit seiner steigenden Flanke ebenfalls, daß an den Anschlußklemmen 20 und 2 Signale mit fallender Flanke auftreten. Diese sorgen dafür, daß das innere Flip-Flop bestehend aus den FETS 7, 8, 17, 18 und das äußere Flip-Flop bestehend aus den FETS 9, 10, 15, 16 deaktiviert werden. Sodann werden die externen Bitleitungen 11, 12 auf die niedrige Versorgungsspannung und die äußeren Datenleitungen 13, 14 auf die höhere Versorgungsspannung vorgeladen. Der eigentliche Auslesevorgang der adressierten Speicherzelle bewirkt ein Differenzsignal auf den externen Bitleitungen 11a,b, 12a.b. Die Bitleitungsteile 11b, 12b werden sodann von den externen Bitleitungsteilen 11a, 12a über die FETS 24, 25 abgetrennt.

Nun wird der eigentliche Bewertungsvorgang durch die Schaltungsanordnung mit der fallenden Flanke des an der Eingangsklemme 22 anliegenden Signals vorgenommen. Zuerst wird das innere Flip-Flop 7, 8, 17, 18 aktiviert und um eine Gatterlaufzeit versetzt das äußere Flip-Flop 9, 10, 15, 16. Nach einer weiteren Gatterlaufzeit werden wie oben beschrieben, die FETS 24, 25 derart angesteuert, daß sie die externen Bitleitungsteile 11a, 12a von den beiden Flip-Flops abtrennen. Durch das versetzte Einschalten, wird zuerst das innere FlipFlop von der reduzierten Spannung getrieben, gesetzt, so dann wird das äußere, von der höheren Spannung getrieben, welches nur über die Gateanschlüsse der Transistoren 15, 16 an gesteuert wird, entsprechend den Signalen des inneren Flip-Flops gesetzt.

Die Vorteile dieser ineinandergesetzten Flip-Flops sind, die Trennung der Schaltungen, die mit niedrigerer Versorgungsspannung und der Schaltungen, die mit höherer Versorgungsspannung betrieben werden. Das innere Flip-Flop wird durch die n-Kanal-Transistoren bestimmt und die Wannen der p-Kanal-Transistoren, die mit der Source an der niedrigeren Spannung angeschlossen sind, können ebenfalls dort angeschlossen werden. Dies verbessert deutlich das Verhalten der Schaltungen bei Erhöhung der höheren Versorgungsspannung.

## Patentansprüche

1. Schaltungsanordnung zum Verstärken und Halten von Daten mit einem ersten in MOS-Technik aufgebauten Flip-Flop (7, 8, 17, 18) und einem zweiten in MOS-Technik aufgebauten Flip-Flop (9, 10, 15, 16), wobei das zweite Flip-Flop (9, 10, 15, 16) mindestens ein Paar von MOS-Transistoren (15, 16) aufweist, deren Laststrecken masseseitig im Ausgangskreis des zweiten Flip-Flops (9, 10, 15, 16) geschaltet sind, und mit Mitteln zum Aktivieren des ersten und zweiten Flip-Flops, welche zum Verstärken und Halten der Daten derart ansteuerbar sind, daß das erste Flip-Flop (7, 8, 17, 18) und daraufhin zeitverzögert das zweite Flip-Flop (9, 10, 15, 16) aktiviert sind, **dadurch gekennzeichnet**, dass
- die Schaltungsanordnung Daten mit verschiedenen Versorgungsspannungen verstärkt und hält,
- Mittel zur Zuführung der Daten mit niedriger Versorgungsspannung zum ersten Flip-Flop vorgesehen sind,
- das erste Flip-Flop dazu geeignet ist, von einer niedrigen Versorgungsspannung versorgt zu werden,
- das zweite Flip-Flop dazu geeignet ist, von einer hohen Versorgungsspannung versorgt zu werden und
- die Ausgangskreisanschlüsse des ersten Flip-Flops (7, 8,17,18) nur jeweils mit den Gate-Anschlüssen des Paares von MOS-Transistoren (15, 16) oder der Paare von MOS-Transistoren des zweiten Flip-Flops (9, 10, 15, 16) verbunden sind.

2. Schaltungsanordnung nach Anspruch 1,
**dadurch gekennzeichnet**,
- daß das erste Flip-Flop zwei p-Kanal-FETS (7, 8) und zwei n-Kanal-FETS (17, 18) aufweist,
- die Laststrecke jeweils eines p-Kanal-FETS (7, 8) und eines n-Kanal-FETS (17, 18) zwischen niedriger Versorgungsspannung und Masse geschaltet sind, wobei die n-Kanal-FETS (17, 18) masseseitig geschaltet sind,
- die Gateanschlüsse der FETS (7, 8, 17, 18) jeweils kreuzweise mit dem Knotenpunkt (C, D) der jeweils anderen Reihenschaltung verbunden sind,
- die Knotenpunkte (C, D) jeweils den Ein- bzw. Ausgangskreis bilden.

3. Schaltungsanordnung nach Anspruch 2,
**dadurch gekennzeichnet,**
daß die Bulkanschlüsse der p-Kanal-FETS (7, 8) mit der niedrigen Versorgungsspannung verbunden sind.

4. Schaltungsanordnung nach einem der Ansprüche 1 bis 3,
**dadurch gekennzeichnet,**
- daß das zweite Flip-Flop weitere zwei p-Kanal-FETS und weitere zwei n-Kanal-FETS aufweist,
- die Laststrecke jeweils eines der weiteren p-Kanal-FETS (9, 10) und eines der weiteren n-Kanal-FETS (15, 16) zwischen Vorversorgungsspannung und Masse geschaltet sind, wobei die n-KanalFETS (15, 16) masseseitig geschaltet sind,
- die Gateanschlüsse der weiteren p-Kanal-FETS (9, 10) jeweils kreuzweise mit dem Knotenpunkt (A, B) der jeweils anderen Reihenschaltung verbunden sind,
- die Gateanschlüsse der weiteren n-Kanal-FETS (15, 16) mit den jeweiligen Ein- bzw. Ausgangskreis des ersten Flip-Flops verschaltet sind.

5. Schaltungsanordnung nach einem der Ansprüche 1 bis 4,
**dadurch gekennzeichnet**,
daß Aktivierungstransistoren (3, 6, 19) zum Aktivieren des ersten bzw. zweiten Flip-Flops vorgesehen sind, daß eine Logikanordnung (21, 23) vorgesehen ist, welche ein Verzögerungsglied (23) enthält, welche ein zeitverzögertes Aktivieren des zweiten Flip-Flops gegenüber dem ersten Flip-Flop gewährleistet.

6. Schaltungsanordnung nach Anspruch 5,
**dadurch gekennzeichnet**,
daß das Verzögerungsglied (23) eine Inverterstufe ist.

## Claims

1. Circuit arrangement for amplifying and holding data, with a first flip-flop (7, 8, 17, 18) designed in MOS technology and with a second flip-flop (9, 10, 15, 16) designed in MOS technology, the second flip-flop (9, 10, 15, 16) having at least one pair of MOS transistors (15, 16) whose load paths are connected on the earth side in the output circuit of the second flip-flop (9, 10, 15, 16), and having means for activating the first and second flip-flops, which, for amplifying and holding the data, can be driven in such a way that the first flip-flop (7, 8, 17, 18) and, with a time delay thereafter, the second flip-flop (9, 10, 15, 16) are activated, characterized in that
- the circuit arrangement amplifies and holds data with different supply voltages,
- means are provided for feeding the data with low supply voltage to the first flip-flop,
- the first flip-flop is suitable for being supplied with a low supply voltage,
- the second flip-flop is suitable for being supplied with a high supply voltage, and
- the output-circuit terminals of the first flip-flop (7, 8, 17, 18) are in each case connected only to the gate terminals of the pair of MOS transistors (15, 16) or of the pairs of MOS transistors of the second flip-flop (9, 10, 15, 16).

2. Circuit arrangement according to Claim 1, characterized
- in that the first flip-flop has two p-channel FETs (7, 8) and two n-channel FETs (17, 18),
- the load paths of, respectively, a p-channel FETs (7, 8) and an n-channel FETs (17, 18) are connected between low supply voltage and earth, the n-channel FETs (17, 18) being connected on the earth side,
- the gate terminals of the FETs (7, 8, 17, 18) are respectively connected cross-wise to the node point (C, D) of the other respective series circuit,
- the node points (C, D) respectively form the input or output circuit.

3. Circuit arrangement according to Claim 2, characterized in that bulk terminals of the p-channel FETs (7, 8) are connected to the low supply voltage.

4. Circuit arrangement according to one of Claims 1 to 3, characterized
- in that the second flip-flop has a further two p-channel FETs and a further two n-channel FETs,
- the load paths of, in each case, one of the further p-channel FETs (9, 10) and one of the further n-channel FETs (15, 16) are connected between presupply voltage and earth, the n-channel FETs (15, 16) being connected on the earth side,
- the gate terminals of the further p-channel FETs (9, 10) are respectively connected cross-wise to the node point (A, B) of the other respective series circuit,
- the gate terminals of the further n-channel FETs (15, 16) are connected to the respective input or output circuit of the first flip-flop.

5. Circuit arrangement according to one of Claims 1 to 4, characterized in that activating transistors (3, 6, 19) for activating the first or second flip-flop are provided, in that a logic arrangement (21, 23) is provided which contains a delay element (23) ensuring delayed activation of the second flip-flop relative to the first flip-flop.

6. Circuit arrangement according to Claim 5, characterized in that the delay element (23) is an inverter stage.

## Revendications

1. Circuit d'amplification et de maintien de données comprenant une première bascule (7, 8, 17, 18) conçue en technique MOS et une seconde bascule (9, 10, 15, 16) conçue en technique MOS, la seconde bascule (9, 10, 15, 16) présentant au moins une paire de transistors MOS (15, 16) dont les lignes de charge sont branchées à la masse au circuit de sortie de la seconde bascule (9, 10, 15, 16), et comprenant des moyens d'activation de la première et de la seconde bascule, qui peuvent être activés pour l'amplification et le maintien des données de telle sorte que la première bascule (7, 8, 17, 18) et ensuite, avec un temps de retard, la seconde bascule (9, 10, 15, 16) soient activées,
caractérisée en ce que
- le circuit amplifie et maintient des données avec des tensions d'alimentation différentes,
- des moyens d'amenée des données à la première bascule à une tension d'alimentation inférieure, sont prévus,
- la première bascule convient à une alimentation avec une tension d'alimentation plus basse,
- la seconde bascule convient à une alimentation avec une tension d'alimentation élevée et
- les bornes des circuits de sortie de la première bascule (7, 8, 17, 18) ne sont connectées qu'aux bornes de grille de la paire de transistor MOS (15, 16) ou des paires de transistors MOS de la seconde bascule (9, 10, 15, 16)

2. Circuit selon la revendication 1,
**caractérisé en ce que**
- la première bascule présente deux FETS (7, 8) de canal p et deux FETS (17, 18) de canal n,
- la ligne de charge d'un FET (7, 8) de canal p et d'un FET (17, 18) de canal n est branchée entre la tension d'alimentation plus basse et la masse, les FETS (17, 18) de canal n étant branchés à la masse,
- les bornes de grille des FETS (7, 8, 17, 18) étant respectivement connectées en croix au point nodal (C, D) de l'autre montage en série respectivement,
- les points nodaux (C, D) forment respectivement le circuit d'entrée ou le circuit de sortie.

3. Circuit selon la revendication 2,
**caractérisé en ce que,**
les bornes du substrat des FETS (7, 8) de canal p sont connectées à la tension d'alimentation basse.

4. Circuit selon l'une des revendications 1 à 3,
**caractérisé en ce que**
- la deuxième bascule comporte deux FETS de canal p supplémentaires et deux FETS de canal n supplémentaires,
- la ligne de charge de l'un des FETS de canal p supplémentaire (9, 10) et de l'un des FETS de canal n supplémentaire (15, 16) est branchée entre la tension de préalimentation et la masse, les FETS (15, 16) de canal n étant branchés à la masse,
- les bornes de grille des FETS de canal p supplémentaires (9, 10) étant connectées en croix respectivement au point nodal (A, B) de l'autre montage en série,
- les bornes de grille des FETS de canal n supplémentaires (15, 16) étant branchées au circuit d'entrée et de sortie respectif de la première bascule.

5. Circuit selon l'une des revendications 1 à 4,
**caractérisé en ce que**
des transistors d'activation (3, 6, 19) sont prévus pour l'activation de la première et de la seconde bascule, en ce qu'une unité logique (21, 23) est prévue, qui comporte un élément retardateur (23), laquelle assure une activation retardée dans le temps de la seconde bascule par rapport à la première.

6. Circuit selon la revendication 5,
**caractérisé en ce que**
l'élément retardateur (23) est un étage inverseur.
